(19) Europäisches Patentamt / European Patent Office / Office européen des brevets

(11) **EP 1 071 213 B1**

(12) **FASCICULE DE BREVET EUROPEEN**

(45) Date de publication et mention
de la délivrance du brevet:
**02.07.2008 Bulletin 2008/27**

(51) Int Cl.:
***H03K 17/18*** *(2006.01)*

(21) Numéro de dépôt: **00410076.4**

(22) Date de dépôt: **17.07.2000**

(54) **Commande d'un transistor MOS de puissance**

Steuerung eines MOS-Leistungstransistors

Control of a MOS power transistor

(84) Etats contractants désignés:
**DE FR GB IT**

(30) Priorité: **20.07.1999 FR 9909562**

(43) Date de publication de la demande:
**24.01.2001 Bulletin 2001/04**

(73) Titulaire: **STMicroelectronics S.A.**
**92120 Montrouge (FR)**

(72) Inventeurs:
• **Bienvenu, Philippe**
**13190 Allauch (FR)**

• **Pavlin, Antoine**
**13540 Puyricard (FR)**

(74) Mandataire: **de Beaumont, Michel**
**1bis, rue Champollion**
**38000 Grenoble (FR)**

(56) Documents cités:
**EP-A- 0 709 961     EP-A- 0 763 746**
**US-A- 5 164 659**

**Description**

La présente invention concerne les circuits intégrant un transistor MOS de puissance avec son circuit de commande.

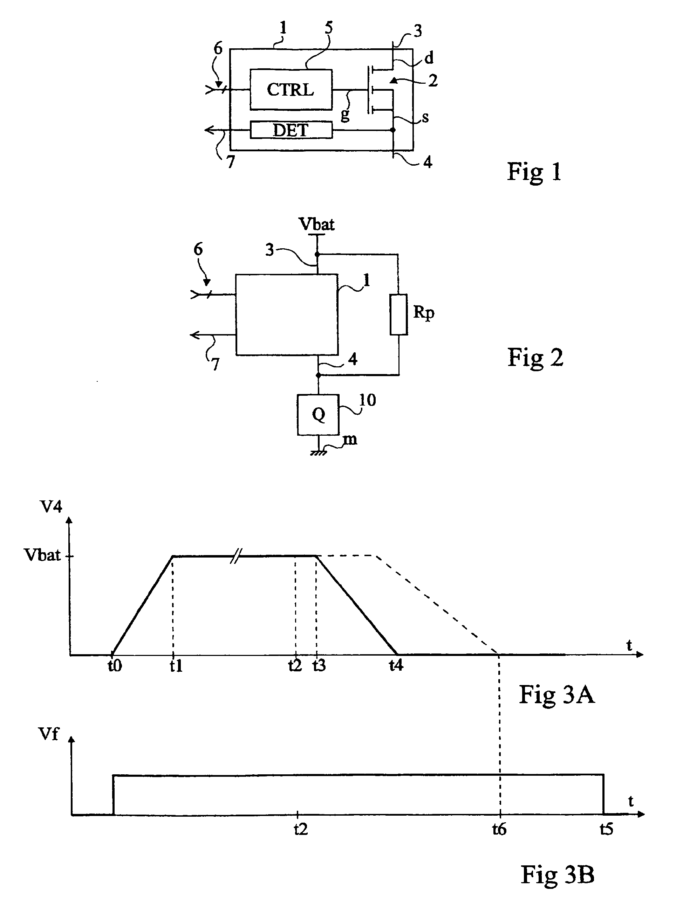

La figure 1 représente, de façon très schématique, un exemple classique de circuit intégré du type auquel se rapporte la présente invention. Ce circuit intégré 1 comprend essentiellement un transistor MOS de puissance 2 dont le drain d et la source s définissent des bornes, respectivement 3 et 4 du circuit intégré en communication avec l'extérieur. La borne 3 correspond à une borne sur laquelle doit être appliquée une tension d'alimentation de la charge commandée par le circuit 1. La borne 4 correspond à une borne de sortie destinée à être connectée à une première borne de la charge à commander, l'autre borne de la charge étant généralement connectée à la masse. Le transistor 2 est commandé par un circuit 5 (CTRL) dont une borne de sortie est connectée à la grille g du transistor 2. Le circuit 5 comprend généralement plusieurs bornes d'entrée (symbolisées par une liaison multifilaire 6) et/ou de paramétrage du fonctionnement du circuit.

Le plus souvent, dans l'utilisation d'un circuit 1 tel qu'illustré par la figure 1, on souhaite également détecter la présence de la charge dans le circuit. Pour ce faire, le circuit 1 comporte en outre une borne 7 propre à délivrer le résultat d'une détection de présence de charge opérée à l'intérieur du circuit 1 par un bloc 8 (DET).

La figure 2 représente, sous forme de schéma blocs, un exemple de montage d'un circuit intégré 1 tel qu'illustré par la figure 1 pour commander une charge 10 (Q). La charge 10 est connectée en série avec le transistor 2 (non représenté à la figure 2) du circuit 1, c'est-à-dire que la borne 3 est connectée à une borne d'alimentation positive d'application d'une tension Vbat, et que la borne 4 est connectée à une première borne de la charge 10 dont une deuxième borne est connectée à la masse m. Dans l'exemple de la figure 2, le montage prévoit la fonction de détection de la présence de la charge entre les bornes 4 et m. La présente invention s'applique plus particulièrement à la détection de charge et, plus précisément, à la détection de présence de la charge non alimentée (c'est-à-dire avec le transistor 2 à l'état bloqué).

Pour détecter la présence d'une charge 10 dans le montage alors que celle-ci n'est pas alimentée, on prévoit une résistance Rp en parallèle avec le transistor 2. En d'autres termes, la résistance Rp est connectée, le plus souvent de façon externe au circuit 1, entre les bornes 3 et 4. Avec un tel montage, si la charge est présente, la borne 4 se trouve à un potentiel correspondant à la masse lorsque le transistor 2 est fermé. Si la charge est absente, c'est-à-dire que la borne 4 est en l'air, cette borne se retrouve à un potentiel positif, ici le potentiel Vbat, à la chute de tension près dans la résistance Rp. La valeur de la résistance Rp est généralement de plusieurs kilo-ohms pour ne pas engendrer de consommation trop importante ni dissiper fortement.

Le document EP-A-0 763 746 illustre cette technique.

Généralement, et en particulier si la valeur de la tension Vbat est différente de la basse tension d'alimentation du circuit 8 de détection, la résistance Rp est connectée entre la borne 4 et une borne (non représentée) d'application d'une tension de polarisation Vpol (par exemple, 5 volts).

L'exploitation de la mesure de tension de la borne 4 par la résistance Rp pose plusieurs problèmes.

Un premier problème est lié au temps de citation du transistor 2. Ce problème est illustré par la figure 3A, qui représente, sous forme de chronogramme, un exemple d'allure de la tension V4 de sortie du circuit 1 pour alimenter la charge Q.

Dans cet exemple, on considère une commande en allumage à un instant t0 qui se traduit par une tension V4 atteignant le niveau de tension Vbat (en négligeant la chute de tension série dans le transistor 2 à l'état passant) à un instant t1. La différence entre les instants t0 et t1 représente le temps de commutation à la fermeture du transistor 2. Dans l'exemple de la figure 3A, on suppose qu'à un instant t2, le circuit 5 commande l'ouverture du transistor 2. Cette commande se traduit, à partir d'un instant t3, par une décroissance de la tension V4 jusqu'à une annulation de celle-ci à un instant t4. L'intervalle de temps entre les instants t2 et t3 correspond au temps de réaction (tdoff) du transistor, c'est-à-dire le retard de sa commutation par rapport au signal de commande reçu. L'intervalle de temps entre les instants t3 et t4 correspond au temps d'ouverture (tf) du transistor, généralement donné comme étant le temps de descente de la tension de la borne 4 entre 90 % et 10 % de la tension Vbat.

La détection de la présence d'une charge en série avec le transistor 2 peut, à l'état ouvert, être polluée par le temps de commutation à l'ouverture du transistor. En effet, si on exploite la mesure du potentiel de la source s du transistor 2 entre les instants t2 et t4, on va détecter une absence de charge, même si celle-ci est présente. Cela est dû au fait que l'état ouvert du transistor est détecté à partir de l'instant t2 où le circuit de commande a donné l'ordre d'ouverture, mais que la disparition du potentiel de la borne 4 si une charge est présente n'intervient qu'à l'issue du temps de commutation.

Par conséquent, on est conduit à retarder l'exploitation de la mesure par rapport à l'instant t2 d'envoi de la commande en ouverture. Ce retard est le plus souvent effectué par un filtrage capacitif. Le temps de filtrage doit alors être adapté au temps de commutation du transistor.

Un autre problème qui se pose pour l'exploitation de cette détection de potentiel afin de déterminer la présence ou l'absence d'une charge alors que le circuit est à l'état ouvert est que le temps de commutation du transistor dépend de la tension Vbat d'alimentation du montage. Par conséquent, on doit prévoir un temps de filtrage correspondant au pire cas possible d'utilisation du montage. Cette situation est illustrée par la figure 3B qui illustre, sous forme de chronogramme, l'allure d'un signal de commande en exploitation de la mesure. Ce signal illustre le délai de filtrage nécessaire. Dans l'exemple des figures 3A et 3B, on suppose que tant que le signal de commande Vf illustré par la figure 3B est dans un état haut, la lecture de la mesure de tension ne peut pas s'effectuer. Par conséquent, ce signal est à l'état haut pendant toute la période (t0-t2) où le transistor est fermé, dans la mesure où on détecte alors la présence de la charge par d'autres moyens (mesure du courant), et entre l'instant t2 et un instant t5 représentant le délai de filtrage nécessaire après l'ordre d'ouverture du transistor. Comme l'illustre la figure 3B, on est généralement contraint, pour garantir une détection correcte, à prendre un délai de filtrage (t2-t5) supérieur à un délai de filtrage minimum (instants t2 à t6) correspondant lui-même au pire cas de commutation en ouverture du transistor 2 (illustré par les pointillés en figure 3A).

Toutes ces précautions conduisent à des temps de filtrage souvent trop longs qui, dans certaines applications, empêchent même la détection de l'absence de charge. C'est le cas, par exemple, si le circuit intégré 1 sert à commander le transistor 2 à des fréquences de l'ordre du kilohertz qui constitue une valeur usuelle dans des applications de modulation par largeur d'impulsion (PWM). Dans de telles applications, on ne peut alors plus détecter l'absence de charge car la marge de sécurité à prendre sur le délai de filtrage n'est pas négligeable, voire dépasse la période de la commande du transistor à l'état fermé.

La présente invention vise à proposer un nouveau circuit de détection de présence de charge qui pallie aux inconvénients des circuits connus.

L'invention vise, en particulier, à proposer une solution qui autorise une détection fiable de présence de charge.

Une première solution consisterait à réduire le temps de commutation du transistor de puissance du circuit.

Une telle solution ne donnerait pas pleinement satisfaction dans la mesure où la réduction du temps de commutation d'un transistor MOS de puissance conduit immanquablement à augmenter le bruit de commutation. Par conséquent, cette solution engendre un problème de bruit qui, le plus souvent, n'est pas souhaitable.

L'invention vise donc également à proposer une solution qui soit compatible avec les autres exigences de fonctionnement du circuit et, en particulier, avec des besoins de faible bruit de commutation.

La présente invention propose de réduire le temps de filtrage à la valeur la plus faible possible.

Pour ce faire, la présente invention prévoit de rendre le temps de filtrage auto-adaptatif en fonction de la tension d'alimentation du circuit.

Plus précisément, la présente invention prévoit un circuit intégré de commande d'un transistor MOS de puissance, comprenant un circuit de détection de la présence d'une charge externe, utilisant un moyen de filtrage pour retarder un instant de prise en compte de la détection par rapport à l'apparition d'une commande en ouverture du transistor de puissance, et des moyens pour asservir le temps de filtrage sur le temps de commutation du transistor de puissance.

Selon un mode de réalisation de la présente invention, où les temps de commutation du transistor de puissance sont paramétrables par la charge/décharge d'un premier condensateur par une première source de courant constant, lesdits moyens de filtrage comprennent une deuxième source de courant constant de décharge d'un condensateur de filtrage, la valeur du courant constant de la seconde source étant proportionnelle à la valeur du courant constant de la première source.

Selon un mode de réalisation de la présente invention, le circuit comporte des moyens pour rendre une tension de précharge du deuxième condensateur proportionnelle à la tension initiale ou finale aux bornes du premier condensateur lors d'une commutation.

L'invention prévoit également un procédé de détection de présence d'une charge en série avec un transistor de puissance intégré avec son circuit de commande, consistant à rendre un temps de filtrage de détection de la tension de sortie du circuit intégré, dépendant du temps de commutation du transistor de puissance.

Selon un mode de réalisation de la présente invention, le procédé consiste à asservir le courant de décharge d'un condensateur de filtrage sur la valeur d'un courant de charge d'un condensateur de paramétrage du temps de commutation du transistor de puissance, et à rendre la tension de précharge du condensateur de filtrage proportionnelle à la tension d'alimentation du circuit intégré.

L'invention concerne en outre un circuit de détection de la présence d'une charge en série avec un transistor de puissance intégré avec son circuit de commande, ce circuit de détection comportant une cellule de filtrage propre à asservir l'instant de prise en compte de la détection sur le temps de commutation du transistor de puissance.

Selon un mode de réalisation de la présente invention, ladite cellule de filtrage comporte un condensateur associé à une source de courant propre à décharger ce condensateur sous un courant constant, ce courant constant étant rendu proportionnel à un courant constant fixant le temps de citation du transistor.

Selon un mode de réalisation de la présente invention, le circuit de détection comporte un moyen pour fixer un temps de filtrage minimum.

Selon un mode de réalisation de la présente invention, ladite cellule de filtrage comprend un pont diviseur résistif connecté en parallèle avec la charge externe, le point milieu du pont diviseur étant connecté, par l'intermédiaire d'une diode, à une première borne du condensateur de filtrage reliée sur une borne d'entrée d'un inverseur dont la borne de sortie délivre le résultat de la détection, une deuxième borne du condensateur de filtrage étant connectée à la masse.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1, 2, 3A et 3B qui ont été décrites précédemment sont destinées à exposer l'état de la technique et le problème posé ;

la figure 4 représente, de façon très schématique et sous forme de blocs, un circuit intégré de commande d'un transistor MOS, pourvu de moyens pour fixer le temps de citation de ce transistor ;

la figure 5 représente un premier mode de réalisation d'un circuit d'adaptation du temps de filtrage selon la présente invention ;

les figures 6A-B illustrent l'application du circuit de l'invention à une détection de présence de charge ;

la figure 7 représente un mode de réalisation plus détaillé d'un circuit selon l'invention ; et

la figure 8 représente un deuxième mode de réalisation d'un circuit intégré de commande.

Les mêmes éléments ont été désignés par les mêmes références aux différentes figures. Pour des raisons de clarté, les chronogrammes ne sont pas à l'échelle et seuls les éléments qui sont nécessaires à la compréhension de l'invention ont été représentés aux figures et seront décrits par la suite. En particulier, le circuit de commande du transistor MOS de puissance n'a pas été détaillé, de même que le circuit d'exploitation de la mesure de détection de présence de charge.

La présente invention tire profit du fait que, dans les circuits intégrés de commande d'un transistor MOS de puissance, on prévoit généralement une possibilité d'adapter le temps de commutation du transistor. Cette adaptation est prévue pour permettre, soit au fabricant, soit à l'utilisateur, de paramétrer le temps de computation en fonction de l'application.

Pour réaliser une telle adaptation, on utilise une source de courant constant interne au circuit intégré et on règle le temps de commutation du transistor en adaptant la valeur d'un condensateur (interne ou externe selon que l'adaptation est effectuée par le fabricant du circuit intégré ou par l'utilisateur).

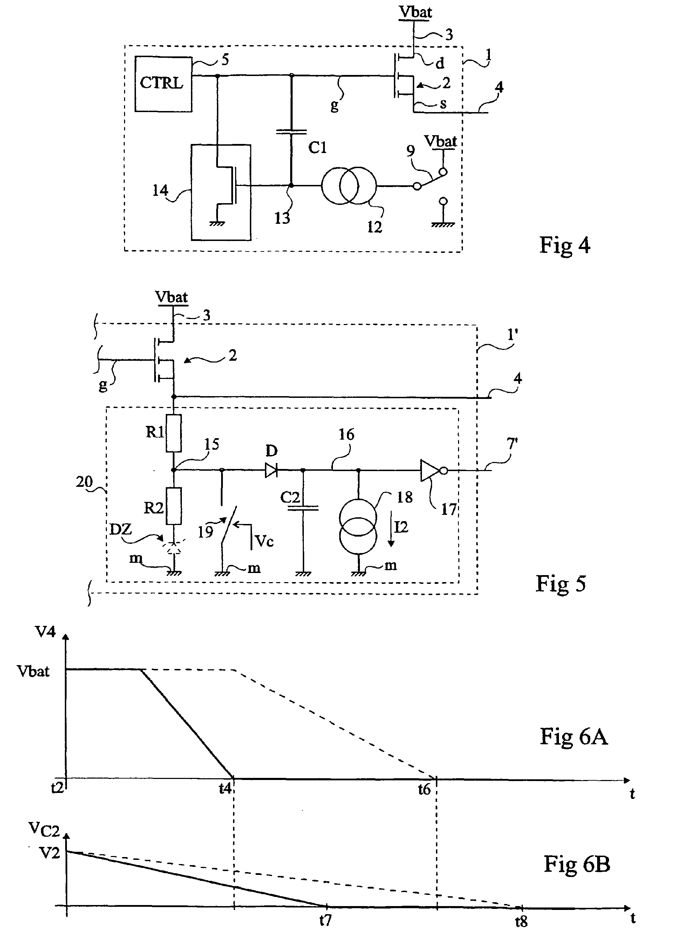

La figure 4 représente, sous forme de schéma blocs, un circuit intégré 1 de commande d'un transistor MOS 2 du type auquel s'applique la présente invention, équipé de moyens de réglage du temps de commutation du transistor. Généralement, le circuit 5 (CTRL) envoyant un signal de commande sur la grille g de commande du transistor 2 comprend un circuit de pompe de charge (non représenté). Pour régler le temps de commutation, on utilise un condensateur Cl dont une première borne est connectée à la grille g du transistor 2 et dont une deuxième borne 13 est reliée à une source de courant 12. La source de courant 12 est une source de courant constant qui, au moyen d'un commutateur 9, est soit alimentée par la tension Vbat d'alimentation du circuit 1, soit reliée à la masse. La commande (non représentée) du commutateur 9 est synchronisée avec la commande du transistor 2, de façon classique. La borne 13 est également connectée à un circuit 14 de commande de la charge de la grille g. Ce circuit de commande est, par exemple, constitué d'un transistor MOS connecté entre la grille g et la masse et dont la propre grille est reliée au noeud 13.

Le réglage des temps de commutation à l'ouverture et à la fermeture utilise le principe de la charge/décharge du condensateur Cl par la source de courant 12. Le potentiel du noeud 13 est sensiblement constant dans la mesure où il est relié à la grille du transistor MOS constitutif du circuit 14. La durée du temps de cotation (intervalle t2-t4 ou t2-t6 à la figure 3A) est donnée par la relation V1.C1/I1, où I1 représente le courant constant de la source 12 et où V1 représente la tension initiale (ouverture) ou finale (fermeture) aux bornes du condensateur C1.

Le circuit de pompe de charge du bloc 5 a pour objet, lors de la fermeture du transistor 2, de porter le potentiel de sa grille g à un potentiel supérieur à celui de sa source s. La variation de potentiel aux bornes du condensateur C1 (initialement déchargé) est alors telle que le courant circule, dans la source 12, de la borne 13 vers la masse. Comme la source 12 est une source de courant constant, le temps de charge du condensateur C1 dépend de la valeur de la tension Vbat. Le rôle du transistor MOS 14 est de contrôler la variation de tension aux bornes du condensateur C1 en rendant sensiblement constant le potentiel du noeud 13 et donc de contrôler la vitesse de charge de la grille du transistor 2.

La commande en ouverture du transistor 2 consiste à annuler le signal envoyé par le bloc 5 pour annuler la tension de grille du transistor 2. Cette tension de grille met toutefois, pour s'annuler, le temps nécessaire à la décharge du condensateur C1. Cette décharge s'effectue par le transistor 14 sous courant constant fixé par la source 12 (de la borne Vbat vers la borne 13). Le transistor 14 absorbe le courant du condensateur C1 fixé par la source 12 et le courant de grille du transistor 2.

Le réglage du temps de commutation en modifiant la capacité du condensateur C1 constitue un mode de réalisation généralement préféré dans ce type de circuit. On notera cependant que, à titre de variante, on peut modifier la capacité d'un condensateur connecté entre le noeud 13 et la source s du transistor 2. La différence essentielle est alors qu'une variation de la valeur du condensateur joue non seulement sur le temps de descente (tf) mais également sur le temps de réaction (tdoff ou tdon). La forme de la courbe obtenue lors des commutations a alors une allure moins linéaire qu'en cas de variation de la capacité du condensateur C1, où la variation est alors similaire à celle illustrée par la figure 3A.

Dans certains cas, on peut, pour modifier les temps de cotation, souhaiter faire varier la valeur du courant dans la source 12 plutôt que celle du condensateur. Toutefois, on préfère généralement faire varier la capacité du condensateur C1 dont la variation intervient moins que la source 12 formée de transistors sur la réalisation du circuit intégré.

Une caractéristique de la présente invention est de rendre le temps de filtrage d'un circuit de détection de présence de charge dépendant du temps de commutation. En d'autres termes, la présente invention vise à rendre le temps de filtrage auto-adaptatif en fonction des variations du temps de commutation.

Selon un mode de réalisation préféré de la présente invention, cet asservissement du temps de filtrage sur le temps de commutation s'effectue en utilisant une source de courant constant, de valeur proportionnelle au courant dans la source 12 et un condensateur de filtrage de valeur proportionnelle à la valeur du condensateur C1.

Une autre caractéristique de la présente invention est de provoquer une précharge du condensateur de la cellule de filtrage à une tension proportionnelle à la tension aux bornes du condensateur C1 lors des commutations, c'est-à-dire dépendant de la tension Vbat.

La figure 5 représente un mode de réalisation d'un circuit de détection de présence de charge selon la présente invention. Ce circuit est, de préférence, intégré avec le reste des éléments de commande du transistor 2 et avec ce dernier dans un circuit 1'. Par souci de simplification, la représentation du circuit 1' à la figure 5 n'est que partielle. En particulier, les éléments de commande du transistor 2 qui sont illustrés en figure 4 n'ont pas été représentés.

Selon la présente invention, on prévoit, en parallèle avec la charge, c'est-à-dire entre la borne 4 et la masse m̲, une cellule de filtrage 20 dont une sortie 7 délivre un état logique indicateur du niveau de potentiel de la source du transistor 2. Cette cellule comprend, entre la borne 4 et la masse m̲, un pont diviseur résistif constitué de résistances R1, R2. Le point milieu 15 du pont diviseur résistif est connecté à l'anode d'une diode D dont la cathode 16 est reliée à une entrée d'un inverseur 17. La sortie de l'inverseur constitue une borne 7' donnant le résultat de la détection. Un condensateur C2 est connecté en parallèle avec une source de courant constant 18 entre la borne 16 et la masse m̲. En outre, un commutateur 19 relie la borne 15 (l'anode de la diode D) à la masse. Ce commutateur 19 est commandé par un signal Vc provenant du circuit de commande 5 et est destiné à arrêter la précharge du condensateur C2 lors de la commande à l'ouverture du transistor 2, afin de commencer alors la décharge du condensateur C2.

La source de courant 18 est réalisée de manière à délivrer un courant I2 constant, proportionnel au courant I1 de la source 12 (figure 4). Comme les deux sources de courant sont réalisées sous forme de circuit intégré, on pourra, selon un premier mode de réalisation, adapter les tailles respectives des transistors MOS de ces sources de courant pour obtenir des courants égaux ou proportionnels. Toutefois, selon un deuxième mode de réalisation préféré, la source de courant 18 sera obtenue à partir d'un ou plusieurs transistors montés en miroir de courant sur un transistor constitutif de la source 12. Un avantage de ce deuxième mode de réalisation est que les variations parasites éventuelles des sources de courant 12 et 18 sont ainsi corrélées.

La valeur de la tension de précharge du condensateur C2 dépend des valeurs des résistances R1 et R2 fixant le coefficient de proportionnalité entre la tension de charge du condensateur C2 et la tension Vout. Ce coefficient fixe la valeur limite maximale de précharge du condensateur C2. Toutefois, celui-ci peut être préchargé à une valeur inférieure par la fermeture de l'interrupteur 19 sous commande du signal Vc. Par conséquent, la tension de précharge du condensateur C2 peut correspondre à la tension Vout (résistance R1 très faible devant la résistance R2), à une fraction de cette tension de sortie, ou à un seuil fixe, par exemple en mesurant la tension aux bornes du condensateur C2 pour fermer le commutateur 19 quand ce seuil est atteint. Le rôle de la diode D est d'empêcher la décharge du condensateur C2 dans le commutateur 19 lorsque ce dernier est fermé.

Une fois préchargé, le condensateur C2 se décharge dans la source de courant 18 avec un courant constant. Par conséquent, le potentiel de la cathode 16, qui est initialement dans un état haut lorsque le condensateur C2 est chargé, va progressivement diminuer jusqu'à atteindre la masse une fois le condensateur C2 intégralement déchargé. L'inverseur 17 permet de mettre en forme le signal devant être délivré sur la borne 7' pour que ses fronts, respectivement montants et descendants, soient francs.

On constate donc que, si la valeur de courant I2 est proportionnelle à la valeur du courant I1 de la source 12 (figure 4), si la valeur du condensateur C2 est proportionnelle à la valeur du condensateur C1 et si la tension V2 de précharge du condensateur C2 est proportionnelle à la tension V1 aux bornes du condensateur C1 lors des commutations, le temps de basculement de l'inverseur 17 par rapport à une commande en ouverture du transistor 2 va suivre les mêmes variations que celles du temps de commutation à l'ouverture de ce transistor. La relation liant le temps de filtrage tC2 au temps de commutation tC1 peut s'écrire sous la forme :

$$tC2 = (Kv.Kc/Ki).tC1,$$

où Kv représente le rapport entre les tensions V2 et V1, Kc représente le rapport entre les capacités respectives des condensateurs C2 et C1, et Ki représente le rapport entre les courants I2 et I1 des sources respectives 18 et 12.

Les figures 6A et 6B illustrent, sous forme de chronogrammes, le fonctionnement d'un circuit selon l'invention. La figure 6A représente deux exemples d'allure de la tension de sortie V4 à la citation vers l'ouverture du transistor 2. La figure 6B illustre les allures correspondantes de la tension Vc2 illustrant la décharge du condensateur C2. Dans les deux cas, on suppose une commande en ouverture à un instant t2. A partir de cet instant t2, le condensateur se décharge depuis le niveau de précharge V2. Dans l'exemple des figures 6A et 6B, on suppose en effet que la tension Vbat est la même pour les deux exemples de commutation. Par conséquent, le niveau de précharge V2 est également le même dans les deux cas. Le tracé en trait plein illustre une commutation relativement rapide entre l'instant t2 et l'instant t4. Le tracé en pointillés illustre une commutation relativement lente entre l'instant t2 et l'instant t6. Le tracé de la figure 6A est à rapprocher de la partie droite de la figure 3A.

Dans l'exemple de la figure 6B, on suppose un mode de réalisation préféré de l'invention dans lequel les coefficients de proportionnalité entre les tensions, courants et capacités respectifs sont tels que Kv.Kc/Ki = 1. Cette condition permet que la variation du temps de filtrage illustrée par la figure 6B pour les deux commutations de la figure 6A soit exactement identique à la variation des temps de commutation. A la figure 6B, on a illustré le cas où le circuit est paramétré pour que la tension Vc2 s'annule à un instant t7, respectivement t8, prédéterminé après les instants respectifs t4 et t6 pour disposer d'une marge de sécurité garantissant une absence de recouvrement des temps de commutation. La durée de cette marge de sécurité dépend bien entendu de l'application et est à la portée de l'homme du métier.

Un avantage de la présente invention est qu'elle permet de s'affranchir des marges de sécurité usuelles pour adapter le temps de filtrage au temps de commutation maximum admissible en fonction des tensions d'alimentation du circuit. En effet, comme l'adaptation du temps de filtrage est ici automatique en fonction d'une variation de la tension Vbat et des autres paramètres fixant les temps de commutation, la marge temporelle de sécurité (t4-t7) peut être réduite au minimum admissible.

Le cas échéant, on peut souhaiter fixer un temps minimal de filtrage indépendamment des conditions des temps de commutation. Pour ce faire, il suffit d'insérer une diode Zener DZ (représentée en pointillés à la figure 5) en série avec la résistance R2 entre la borne 15 et la masse. La valeur seuil de la diode Zener fixe alors une tension de précharge minimale indépendamment des conditions de variation de la tension d'alimentation Vbat qui conditionne la tension V2 dans le cas usuel.

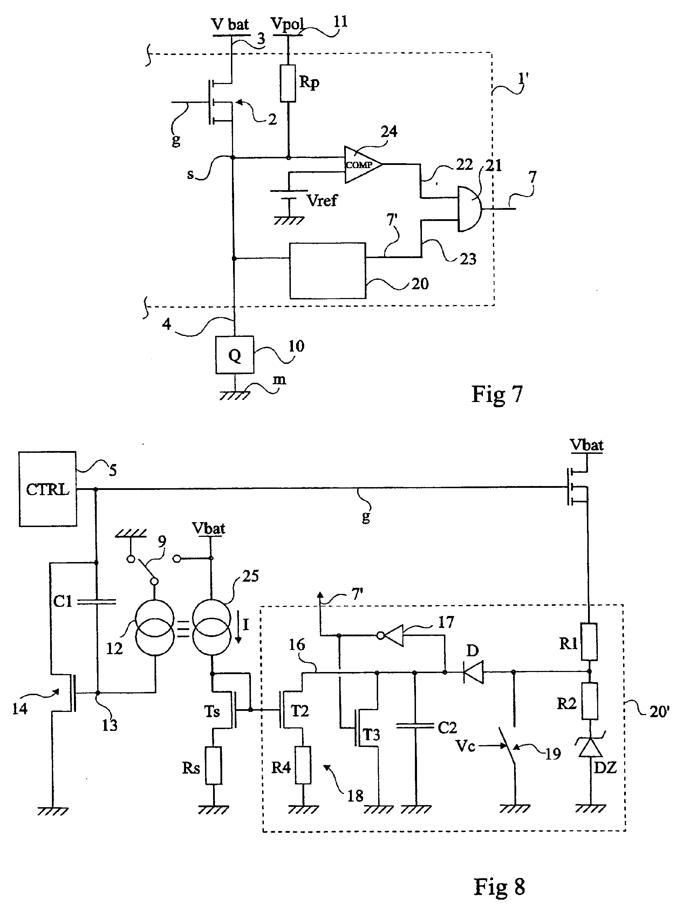

La figure 7 représente un mode de réalisation d'un circuit 1' selon l'invention exploitant une cellule de filtrage 20 telle qu'illustrée par la figure 5 pour fournir sur une borne 7 un diagnostic sur la présence ou non d'une charge 10 en série avec le transistor 2, entre une borne 3 de fourniture d'une tension Vbat et la masse m. Comme à la figure 5, la représentation de la figure 7 est partielle.

De façon classique, pour détecter la présence d'une charge alors que l'interrupteur 2 est ouvert, on prévoit une résistance Rp entre une borne 11 d'application d'un potentiel de polarisation (pouvant être confondu avec la tension Vbat) et la borne 4. Le rôle de cette résistance est, toujours de façon classique, de porter le potentiel de la borne 4 à la valeur Vpol (à la chute de tension dans la résistance Rp près) en cas d'absence de la charge 10. Si la charge est présente, cette borne 4 se retrouve à la masse.

Le résultat de la détermination de présence de charge sur la borne 7 est, dans l'exemple de la figure 7, délivré par une porte logique ET 21 dont une première entrée 22 reçoit le résultat de la comparaison du potentiel de la borne 4 avec une tension de référence Vref et dont la deuxième entrée 23 est reliée à la sortie 7' d'une cellule de filtrage 20 telle qu'illustrée par la figure 5. Le signal de la borne 22 est délivré par un comparateur 24 dont une première entrée est connectée à la borne 4 et dont une deuxième entrée reçoit la tension Vref. Le rôle de la porte ET 21 est de ne prendre en compte le résultat de la détection par le comparateur 24 qu'à l'issue du temps fixé par la cellule de filtrage 20. Le cas échéant, le comparateur 24 pourra être remplacé par un inverseur, ce qui revient à rendre interne (et au milieu de la plage de tension d'alimentation) le seuil de basculement du comparateur.

En fonctionnement normal, c'est-à-dire lorsque le circuit 1' est correctement alimenté, la borne 22 est en permanence à l'état haut de sorte que l'état de sortie de la porte 21 est uniquement conditionné par le résultat délivré par la cellule 20. Comme cela a été indiqué précédemment, le fonctionnement de cette cellule 20 étant rendu dépendant des temps de commutation du transistor 2, le basculement de sa sortie s'effectue, de façon certaine, à bon escient.

On notera que la cellule de filtrage 20 peut être utilisée indifféremment pour générer un délai à la fermeture du transistor 2 ou à l'ouverture de ce transistor. En effet, on constate aisément que l'état de la sortie 7' de la cellule 20 est retardé de la même façon proportionnellement au temps de commutation du transistor 2 lors de sa fermeture. Par conséquent, le signal de sortie 7' peut également être utilisé, selon les besoins de l'application, pour exploiter un résultat de fermeture qui est rendu fiable grâce à l'auto-adaptation de la réaction de la cellule de filtrage sur le temps de commutation.

La figure 8 représente un deuxième mode de réalisation d'un circuit intégré de commande d'un transistor de puissance 2, équipé d'une cellule de filtrage 20' selon la présente invention.

Selon le mode de réalisation de la figure 8, la source de courant 18 de la cellule de filtrage 20' est obtenue à partir d'une source de courant 25 montée en miroir de courant sur la source 12. Par conséquent, on a représenté une source de courant constant I 25 dont un transistor de sortie Ts est destiné à être monté en miroir de courant sur un transistor T2 constitutif de la source de courant 18. Le transistor Ts est connecté en série avec une résistance Rs et la source 25 entre une borne d'application de la tension Vbat et la masse m. Le transistor T2 est connecté, en série avec une résistance R4, entre le noeud 16 de la cellule 20' et la masse. La source 12 a été représentée comme en figure 4, c'est-à-dire connectée entre le noeud 13 et un commutateur 9 de sélection entre la masse et le potentiel Vbat, pour fixer le sens de circulation du courant dans la source 12. Le reste du circuit d'adaptation des temps de commutation (condensateur C1, transistor 14 et source de courant 12) est similaire à celui décrit en relation avec la figure 4. On notera ici simplement que les courants des sources 12 et 18 sont parfaitement corrélés, le rapport Ki dépendant des valeurs respectives des résistances en série avec les transistors de ces sources et des rapports largeur sur longueur de grille respectifs des transistors qui les constituent.

Côté cellule de filtrage 20', celle-ci reprend les éléments décrits en relation avec la figure 5.

Une caractéristique du mode de réalisation de la cellule 20' de la figure 8 est qu'un commutateur, par exemple un transistor MOS T3, est connecté en parallèle avec le condensateur C2, la grille du transistor T3 étant reliée à la borne 7'. Le rôle de ce transistor T3 est de forcer la décharge du condensateur C2 dès que la sortie 7' de la cellule 20' a basculé. On améliore ainsi la fiabilité du système dans la mesure où on garantit que le condensateur C2 est toujours initialement déchargé.

Un avantage de la présente invention est qu'il est désormais possible d'utiliser un circuit intégré tel qu'illustré par la figure 4 et comprenant une cellule de filtrage telle qu'illustrée par la figure 5 ou 8 pour détecter la présence d'une charge en série avec l'interrupteur de puissance 2, même si celui-ci doit être commandé à une fréquence relativement élevée, par exemple, à une fréquence de plusieurs dizaines de kilohertz en modulation de largeur d'impulsion.

Bien entendu, la présente invention est susceptible de diverses variantes et modifications qui apparaîtront à l'homme de l'art. En particulier, le dimensionnement des différents composants de la cellule de filtrage de l'invention est à la portée de l'homme du métier en fonction de l'application et, en particulier, de la plage de fonctionnement en tension d'alimentation du circuit. De plus, bien que l'on ait fait référence dans la description qui précède à une adaptation de la charge du condensateur C2 en fonction de la tension Vbat, on notera qu'il est également possible d'adapter le courant délivré par la source 18 et de maintenir la tension de précharge V2 constante. L'adaptation du circuit de l'invention pour la mise en oeuvre d'une telle variante est à la portée de l'homme de métier à partir des indications fonctionnelles données ci-dessus.

On notera que tous les composants de la cellule de filtrage de l'invention peuvent être réalisés sous forme de circuit intégré. En particulier, les différentes résistances (y compris la résistance Rp) peuvent avoir des valeurs compatibles avec la réalisation de résistances en silicium polycristallin. De plus, les valeurs des condensateurs Cl et C2 sont compatibles avec une intégration.

**Revendications**

1. Circuit intégré (1') de commande d'un transistor MOS (2) de puissance, comprenant un circuit de détection de la présence d'une charge externe (10), utilisant un moyen de filtrage pour retarder un instant de prise en compte de la détection par rapport à l'apparition d'une commande en ouverture du transistor de puissance, **caractérisé en ce qu'**il comporte des moyens pour asservir le temps de filtrage sur le temps de commutation du transistor de puissance.

2. Circuit selon la revendication 1, dans lequel les temps de commutation du transistor de puissance (2) sont paramétrables par la charge/décharge d'un premier condensateur (C1) par une première source (12) de courant constant, **caractérisé en ce que** lesdits moyens de filtrage comprennent une deuxième source (18) de courant constant de décharge d'un condensateur de filtrage (C2), la valeur du courant constant de la seconde source étant proportionnelle à la valeur du courant constant de la première source.

3. Circuit selon la revendication 2, **caractérisé en ce qu'**il comporte des moyens pour rendre une tension de précharge du deuxième condensateur (C2) proportionnelle à la tension initiale ou finale aux bornes du premier condensateur (C1) lors d'une commutation.

4. Procédé de détection de présence d'une charge (10) en série avec un transistor de puissance (2) intégré avec son circuit de commande, **caractérisé en ce qu'**il consiste à rendre un temps de filtrage de détection de la tension de sortie du circuit intégré, dépendant du temps de commutation du transistor de puissance.

5. Procédé selon la revendication 4, **caractérisé en ce qu'**il consiste à :

   asservir le courant de décharge d'un condensateur (C2) de filtrage sur la valeur d'un courant (I1) de charge d'un condensateur (C1) de paramétrage du temps de commutation du transistor de puissance ; et
   rendre la tension de précharge du condensateur de filtrage proportionnelle à la tension d'alimentation du circuit intégré.

6. Circuit de détection de la présence d'une charge en série avec un transistor de puissance (2) intégré avec son circuit de commande, **caractérisé en ce qu'**il comporte une cellule (20') de filtrage propre à asservir l'instant de prise en compte de la détection sur le temps de commutation du transistor de puissance.

**7.** Circuit selon la revendication 6, **caractérisé en ce que** ladite cellule de filtrage (20') comporte un condensateur (C2) associé à une source de courant (18) propre à décharger ce condensateur sous un courant constant, ce courant constant étant rendu proportionnel à un courant constant fixant le temps de commutation du transistor (2).

**8.** Circuit selon la revendication 7, **caractérisé en ce qu'**il comporte un moyen (DZ) pour fixer un temps de filtrage minimum.

**9.** Circuit selon la revendication 7 ou 8, **caractérisé en ce que** ladite cellule de filtrage (20') comprend un pont diviseur résistif (R1, R2) connecté en parallèle avec la charge externe (10), le point milieu (15) du pont diviseur étant connecté, par l'intermédiaire d'une diode (D), à une première borne (16) du condensateur de filtrage (C2) reliée sur une borne d'entrée d'un inverseur (17) dont la borne de sortie (7') délivre le résultat de la détection, une deuxième borne du condensateur de filtrage étant connectée à la masse.

**Claims**

**1.** A integrated circuit (1') for controlling a power MOS transistor (2), including a circuit for detecting the presence of an external load (10), using filtering means for delaying a time of taking the detection into account with respect to the occurrence of a turn-on control signal of the power transistor, **characterized in that** it comprises means for controlling the filtering time with the switching time of the power transistor.

**2.** The circuit of claim 1, wherein the switching times of the power transistor (2) can be parameterized by the charge/discharge of a first capacitor (C1) by a first constant current source (12), **characterized in that** said filtering means include a second constant current source (18) for discharging a filtering capacitor (C2), the value of the constant current of the second source being proportional to the value of the constant current of the first source.

**3.** The circuit of claim 2, **characterized in that** it includes means for making a voltage of precharge of the second capacitor (C2) proportional to the initial or final voltage across the first capacitor (C1) in a switching.

**4.** A method for detecting the presence of a load (10) in series with a power transistor (2) integrated with its control circuit, **characterized in that** it consists of making a filtering time of detection of the output voltage of the integrated circuit dependent on the switching time of the power transistor.

**5.** The method of claim 4, **characterized in that** it consists of:

controlling the discharge current of a filtering capacitor (C2) with the value of a charge current (I1) of a capacitor (C1) for parameterizing the switching time of the power transistor; and making the precharge voltage of the filtering capacitor proportional to the integrated circuit supply voltage.

**6.** A circuit for detecting the presence of a load in series with a power transistor (2) integrated with its control circuit, **characterized in that** it includes a filtering cell (20') adapted to controlling the time of taking the detection into account with the switching time of the power transistor.

**7.** The circuit of claim 6, **characterized in that** said filtering cell (20') includes a capacitor (C2) associated with a current source (18) adapted to discharging the capacitor under a constant current, this constant current being made proportional to a constant current determining the switching time of the transistor (2).

**8.** The circuit of claim 7, **characterized in that** it includes means (DZ) for determining a minimum filtering time.

**9.** The circuit of claim 7 or 8, **characterized in that** said filtering cell (20') includes a resistive dividing bridge (R1, R2) connected in parallel with the external load (10), the midpoint (15) of the dividing bridge being connected, via a diode (D), to a first terminal (16) of the filtering capacitor (C2) connected on an input terminal of an inverter (17), the output terminal (7') of which provides the result of the detection, a second terminal of the filtering capacitor being grounded.

**Patentansprüche**

**1.** Eine integrierte Schaltung (1') zum Steuern eines MOS Leistungstransistors (2), einschließlich einer Schaltung zum Detektieren der Präsenz von einer externen Last (10), unter Verwendung von Filterungsmitteln zum Verzögern einer Zeit, um die Detektion zu berücksichtigen und zwar mit Bezug auf das Auftreten von einem Einschaltsteuersignal von dem Leistungstransistor, **dadurch gekennzeichnet, dass** sie Mittel aufweist zum Steuern der Filterungszeit mit der Schaltzeit von dem Leistungstransistor.

2. Schaltung nach Anspruch 1, wobei die Schaltzeiten von dem Leistungstransistor (2) parametrisiert werden können durch die Ladung/Entladung von einem ersten Kondensator (C1) durch eine erste Konstantstromquelle (12), **dadurch gekennzeichnet dass** die Filterungsmittel eine zweite Konstantstromquelle (18) zum Entladen eines Filterungskondensators (C2) beinhalten, wobei der Wert des konstanten Stroms von der zweiten Quelle proportional ist zu dem Wert von dem konstanten Strom von der ersten Quelle.

3. Schaltung nach Anspruch 2, **dadurch gekennzeichnet, dass** sie Mittel aufweist, um eine Spannung von einer Vorladung von dem zweiten Kondensator (C2) proportional zu der initialen oder finalen Spannung über den ersten Kondensator (C1) bei einem Schalten, zu machen.

4. Ein Verfahren zum Detektieren der Präsenz von einer Last (10) in Reihe mit einem Leistungstransistor (2) der mit seiner Steuerschaltung integriert ist, **dadurch gekennzeichnet dass** es besteht aus dem Abhängigmachen einer Filterungszeit der Detektion der Ausgangsspannung von der integrierten Schaltung von der Schaltzeit von dem Leistungstransistor.

5. Verfahren nach Anspruch 4, **dadurch gekennzeichnet dass** es aus Folgendem besteht:

   Steuern des Entladestroms von einem Filterungskondensator (C2) mit dem Wert von einem Ladestrom (I1) von einem Kondensator (C1) zum Parametrisieren der Schaltzeit von dem Leistungstransistor; und
   Proportionalmachen der Vorladungsspannung von dem Filterungskondensator zu der Versorgungsspannung von der integrierten Schaltung.

6. Eine Schaltung zum Detektieren der Präsenz von einer Last in Reihe mit einem Leistungstransistor (2) und zwar integriert mit seiner Steuerschaltung, **dadurch gekennzeichnet, dass** sie eine Filterungszelle (20') beinhaltet, die angepasst ist zum Steuern der Zeit um die Detektion mit der Schaltzeit von dem Leistungstransistor zu berücksichtigen.

7. Schaltung nach Anspruch 6, **dadurch gekennzeichnet dass** die Filterungszelle (20') einen Kondensator (C2) beinhaltet, der mit einer Stromquelle (18) assoziiert ist, die angepasst ist zum Entladen des Kondensators mit einem konstanten Strom, wobei dieser konstante Strom proportional gemacht wird, zu einem konstanten Strom, der die Schaltzeit von dem Transistor (2) bestimmt.

8. Schaltung nach Anspruch 7, **dadurch gekennzeichnet dass** sie Mittel (DZ) beinhaltet zum Bestimmen einer minimalen Filterungszeit.

9. Schaltung nach Anspruch 7 oder 8 **dadurch gekennzeichnet dass** die Filterungszelle (20') einen Widerstandsbrückenteiler (R1, R2) beinhaltet, der parallel mit der externen Last (10) verbunden ist, wobei der Mittenabgriff bzw. Mittelpunkt (15) von dem Brückenteiler über eine Diode (D) verbunden ist, mit einem ersten Anschluss (16) von dem Filterungskondensator (C2) der mit einem Eingangsanschluss von einem Inverter (17) verbunden ist, dessen Ausgangsanschluss (7') das Ergebnis von der Detektion vorsieht, wobei ein zweiter Anschluss von dem Filterungskondensator geerdet ist.

Fig 1

Fig 2

Fig 3A

Fig 3B

Fig 4

Fig 5

Fig 6A

Fig 6B

Fig 7

Fig 8

## RÉFÉRENCES CITÉES DANS LA DESCRIPTION

**Documents brevets cités dans la description**

- EP 0763746 A